# EUROPÄISCHE PATENTANMELDUNG

(11) **EP 2 760 095 A1**
(43) Veröffentlichungstag der Anmeldung: **30.07.2014**
(21) Anmeldenummer: 13152296.3
(22) Anmeldetag: 23.01.2013
(51) Int. Cl.: H02H 9/04, H01B 17/28, H01R 13/53, G01R 31/12

(54) **Messsystem zur Dauerüberwachung einer Hochspannungsdurchführung**

(71) Anmelder: Siemens Aktiengesellschaft, 80333 München (DE)
(72) Erfinder: Kutzner, Rüdiger, Dr., 90513 Zirndorf (DE); Weber, Marc, 90441 Nürnberg (DE)

(57) **Zusammenfassung**

Die Erfindung betrifft ein Messsystem zur Dauerüberwachung einer Hochspannungsdurchführung. Sollen am Messanschluss einer Hochspannungsdurchführung dauerhaft Messungen zur Überwachung durchgeführt werden, so muss der Messanschluss vor Verlust der Messbürde geschützt werden. Dazu wird ein Messsystem angegeben, dass einen mehrstufigen, sicheren Schutz gewährleistet. Ein erfindungsgemäßes Messsystem besteht aus einer Messschaltung, einem Anschlussstecker, einem Verbindungskabel und einer zweistufigen Schutzschaltung. Jede Stufe der Schutzschaltung kann bei am Messanschluss auftretenden Überspannungen einen Kurzschluss am Messanschluss herstellen und so die Spannung am Messanschluss begrenzen. Eine erste Schutzstufe spricht dabei bei einer Ansprechspannung U1 an, eine zweite, zwischen erste Schutzstufe und Messanschluss geschaltete, bei einer Ansprechspannung U2. Dabei ist U2 größer als U1. Außerdem sind erste und zweite Schutzstufe durch einen Tiefpassfilter in der ersten Schutzstufe entkoppelt. Dadurch spricht die erste Stufe auf betriebsfrequente Überspannungen an, die zweite auf hochfrequente.

## Beschreibung

Die Erfindung betrifft ein Messsystem zur Dauerüberwachung einer Hochspannungsdurchführung gemäß dem Oberbegriff des Patentanspruchs 1.

Transformatoren und ihre Komponenten sind wichtige Teile des Stromversorgungsnetzes. Ihr Ausfall kann zur Abschaltung von Kraftwerken oder Netzabschnitten führen, was beträchtliche Kosten verursachen kann. Das Versagen von Hochspannungsdurchführungen, zählt mit zu den häufigsten Fehlerursachen von Transformatoren, insbesondere von Leistungstransformatoren. Diese wurden jedoch bislang nur bei routinemäßigen Wartungen überprüft. Problematisch daran waren die langen Intervalle zwischen den Messungen, welche eine rechtzeitige Fehlererkennung nicht immer ermöglichten. In letzter Zeit werden allerdings mehr und mehr Messsysteme gefordert, die eine Dauerüberwachung (Online-Monitoring) von Hochspannungsdurchführungen ermöglichen sollen. Ein Kurzüberblick ist dazu in "Hochspannungstechnik: Grundlagen - Technologie - Anwendungen" von Andreas Küchler (Kapitel 6.4.8.2 der Auflage 2009, ISBN 978-3-540-78412-8) zu finden. Weitere Beschreibungen solcher Messsysteme, der Anforderungen und Möglichkeiten sind in einer Vielzahl von Fachartikeln, beispielsweise in Liebschner et al. "Online-Monitoring of Capacitance and Dissipation Factor of High Voltage Bushings at Service Temperature" (15th ISH International Symposium on High Voltage Engineering, Ljubljana, 2007).

Für elektrische Messungen besitzen Hochspannungsdurchführungen in der Regel einen Messanschluss, der mit dem äußersten kapazitiven Schichtbelag der Hochspannungsdurchführung verbunden ist und der zum Anschluss eines Messsystems zur Messung von Kapazität, Verlustfaktor, Isolationswiderstand oder von Polarisations- und Depolaritsationsströmen genutzt werden kann. Der Messanschluss selber hat dabei einen Erdpol, der häufig durch das geerdete Gehäuse oder einen geerdeten Flansch gebildet wird, und einen Hochspannungspol, der isoliert durch das Gehäuse der Hochspannungsdurchführung nach außen geführt ist. Ist kein Messsystem an den Messanschluss angeschlossen, müssen der Erdpol und der Hochspannungspol des Messanschlusses kurzgeschlossen werden. Andernfalls würde durch die hohe Spannung zwischen Hochspannungspol und Erdpol die Isolation des Messanschlusses mit der Zeit zerstört, wodurch in der Folge auch die Isolierung im Inneren der Durchführung zerstört wird, was zu einer Havarie der Durchführung führt und damit zum Ausfall des Transformators. Dabei können erhebliche Schäden an in der Nähe befindlichen Schaltanlagen oder Personen auftreten. Eine am Messanschluss liegende Spannung, die sofort oder auch erst bei längerem Anliegen zu einer Zerstörung der Isolation des Messanschlusses führt, wird in der Folge als Überspannung bezeichnet.

Bei angeschlossenem Messsystem begrenzt eine Messbürde in der Messschaltung des Messystems die am Messanschluss anliegende Spannung, so dass die Isolation des Messanschlusses nicht beeinträchtigt wird. Bei Verlust der Messbürde, beispielsweise durch Korrosion, Alterung oder Kabelbruch, würden die oben beschriebenen Fehlermechanismen allerdings wieder auftreten. Somit muss ein dauerhaft angeschlossenes Messsystem als zusätzliche Fehlerquelle für den Ausfall einer Hochspannungsdurchführung angesehen werden. Außerdem ist beim Betrieb eines solchen Messsystems der Messanschluss anfällig für Blitzeinschläge in der Nähe der Durchführung. Diese können ebenfalls zu Überspannungen am Messanschluss und damit zur Schädigung des Messanschlusses oder des Messsystems führen. Deswegen sind Vorkehrungen zum Schutz des Messanschlusses vor Überspannung, sei es durch den Verlust der Messbürde oder Blitzeinschläge, zu treffen.

In der Firmenschrift "ABB, Bushing Potential Device, Type PBA2" ist ein solches Messsystem, das die an der Hochspannungsdurchführung anliegende Spannung misst, beschrieben. Dort schützt eine Funkenstrecke den Messanschluss vor Überspannungen. Mit einem Erdungsschalter kann der Messanschluss zusätzlich manuell kurzgeschlossen werden.

Nachteilig am bekannten Stand der Technik ist, dass diese Schutzschaltungen dem Bedürfnis der Betreiber von Transformatoren mit solchen Hochspannungsdurchführen nach einem ausfallsicheren Langzeitschutz des Messanschlusses nicht genügen.

Aufgabe der vorliegenden Erfindung ist es, ein Messsystem anzugeben, das einen hohen Schutz des Messanschlusses vor Überspannungen gewährleistet.

Die Aufgabe wird mit den Mitteln der Erfindung gemäß Patentanspruch 1 gelöst.

Dazu ist ein Messsystem vorgesehen, das zur Dauerüberwachung einer Hochspannungsdurchführung, insbesondere einer Gehäusedurchführung eines Leistungstransformators geeignet ist, und zumindest folgende Komponenten aufweist:
- eine Messschaltung zur Überwachung der Hochspannungsdurchführung,
- einen Anschlussstecker zum Anschluss der Messschaltung an einen Messanschluss der Hochspannungsdurchführung,
- ein Verbindungskabel zur Verbindung der Messschaltung mit dem Anschlussstecker, und
- eine Schutzschaltung zum Schutz des Messanschlusses vor Überspannungen, die dazu ausgebildet ist, einen Kurzschluss zwischen einem Hochspannungspol und einem Erdpol des Messanschlusses bei Auftreten einer Überspannung herzustellen, wobei die Schutzschaltung eine erste Schutzstufe mit einer ersten Ansprechspannung und dazu elektrisch parallel geschaltet eine zweite Schutzstufe mit einer zweiten Ansprechspannung aufweist.

Dabei ist als Kurzschluss im Sinne der Erfindung zu verstehen, dass Hochspannungspol und Erdpol derart miteinander elektrisch verbunden werden, dass am Messanschluss eine für dessen Isolierung unkritische Spannung anliegt.

Erfindungsgemäß ist vorgesehen, dass die zweite Ansprechspannung größer als die erste Ansprechspannung ist, dass die zweite Schutzstufe zwischen Messanschluss und erster Schutzstufe geschaltet ist und dass die erste Schutzstufe einen Tiefpassfilter aufweist. Die erste und zweite Schutzstufe sprechen so bevorzugt auf unterschiedliche eine Überspannung auslösende Ereignisse an und dienen gleichzeitig als gegenseitige Rückfallebene. Dies gewährleistet einen besonders hohen Schutz des Messanschlusses vor Überspannungen.

Bevorzugt weist die erste Schutzstufe in einem den Hochspannungspol mit dem Erdpol verbindenden Schaltungszweig einen Varistor oder eine Suppressordiode auf. Diese Bauelemente schalten schnell und können eine Überspannung sicher zur Erde hin ableiten und sind außerdem kostengünstig.

In einer weiteren bevorzugen Ausführungsform weist die zweite Schutzstufe in einem den Hochspannungspol mit dem Erdpol verbindenden Schaltungszweig eine Funkenstrecke auf. Funkenstrecken habe eine besonders hohe Stromtragfähigkeit und bieten so auch bei hohen Strömen einen zuverlässigen Schutz.

Besonders vorteilhaft ist eine dritte Schutzstufe zwischen dem Messanschluss und der ersten Schutzstufe parallel zum Messanschluss geschaltet und weist einen mechanischen Schalter auf, durch den bei Anliegen einer dritten Ansprechspannung der Kurzschluss herstellbar ist. Da mechanische Schalter als robust und ausfallsicher gelten, wird hierdurch ein nochmals verbesserter Schutz gewährleistet.

In einer vorteilhaften Ausgestaltung der Erfindung ist vorgesehen, dass die dritte Schutzstufe eine Reihenschaltung aus einer Funkenstrecke, einem Gleichrichter und einer Spule aufweist, und der mechanische Schalter durch einen Stromfluss durch die Spule schaltbar ist. Schalter und Spule bilden so ein Reed-Relais. Hierdurch wird der Schalter bei Anliegen der Ansprechspannung und den dadurch verursachten Stromfluss durch die Spule geschlossen und stellt so sicher und ohne notwendigen manuellen Eingriff den Kurzschluss des Messanschlusses her, wodurch ein weiter verbesserter Schutz erreicht wird.

Es wird außerdem bevorzugt, dass das Reed-Relais bistabil ist. Ist der Schalter einmal geschlossen, bleibt er das dadurch auch, wenn die Spule nicht mehr stromdurchflossen wird. Spricht die dritte Schutzstufe an, was bevorzugt bei Ausfall der ersten und zweiten Schutzstufe und Anliegen einer Überspannung, die größer ist, als die Ansprechspannung U3, der Fall ist, so wird der Kurzschluss dadurch besonders sicher dauerhaft hergestellt.

Vorteilhaft ist auch, dass zumindest eine der Schutzstufen redundant ausgelegt ist. Bevorzugt werden die erste und oder die zweite Schutzstufe redundant ausgelegt und bilden so eine zusätzliche Ausfallsicherung.

Des Weiteren sieht eine vorteilhafte Ausgestaltung der Erfindung vor, dass die Schutzschaltung im Anschlussstecker integriert ist. Bevorzugt werden die erste, die zweite und die dritte Schutzstufe der Schutzschaltung in den Anschlussstecker integriert. Ein Verbindungskabel vom Anschlussstecker zur Schutzschaltung wird somit überflüssig, eine potentielle Fehlerursache damit eliminiert. Der Anschlussstecker kann zusätzlich so gedichtet sein, dass er den Messanschluss gegen Eindringen von Luft oder Feuchtigkeit schützt und/oder eine mechanische Verschlusssicherung aufweisen, die verhindert, dass der Anschlussstecker unbeabsichtigt oder durch Erschütterungen vom Messanschluss entfernt werden kann.

Im Folgenden wird die Erfindung anhand der Zeichnungen näher erläutert. Dabei zeigen:
- Figur 1: eine skizzierte Darstellung eines an einer Durchführung eines Transformators angeschlossenen Messsystems,
- Figur 2: ein Ersatzschaltbild Anordnung nach Figur 1,
- Figur 3: eine Schaltskizze eines erfindungsgemäßen Messsystems und
- Figur 4: Eine Skizze einer Ausführungsform eines erfindungsgemäßen Messsystems.

Einander entsprechende Teile sind in allen Figuren mit den gleichen Bezugszeichen versehen.

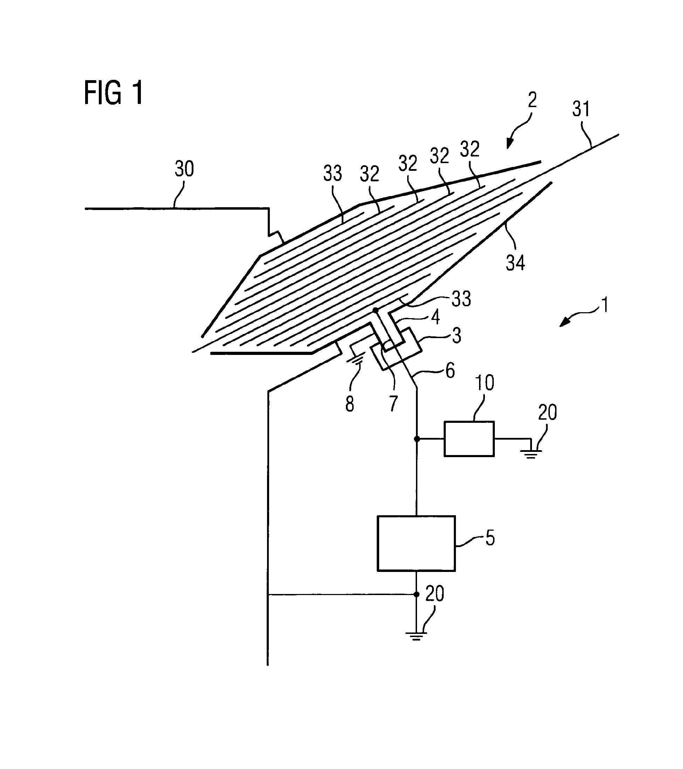

Figur 1 zeigt ein erfindungsgemäßes, an den Messanschluss 4 der Hochspannungsdurchführung 2 eines Leistungstransformators 30 angeschlossenes Messsystem 1. Aus einem Transformator 30 ist ein eine Hochspannung führender Leiter 31 herausgeführt. Zur Isolation des Leiters 31 gegen das geerdete Gehäuse des Transformators 30 dient eine Hochspannungsdurchführung 2, hier mit kapazitiver Feldsteuerung. Zylindrische, in der Länge abgestufte leitfähige Steuerbeläge 32, 33 dienen der Steuerung der elektrischen Felder, insbesondere an den Enden der Hochspannungsdurchführung 2. Der äußerste Steuerbelag 33 wird auch Erdbelag genannt, da er dem Erdpotential am Nächsten ist. Ohne angeschlossenes Messsystem 1 ist der Erdbelag 32 üblicherweise geerdet. Zwischen den Steuerbelägen 32, 33 befindet sich ein nicht dargestelltes Dielektrikum. Damit wirken benachbarte Steuerbeläge 32, 33 wie Kondensatoren. Der Raum zwischen dem Leiter 31 und dem Erdbelag 33 wird so in eine Vielzahl von Teilkapazitäten aufgeteilt. Zur besseren Darstellung sind hier nur wenige Steuerbeläge 32 gezeigt.

Die Durchführung weist ein isolierendes Gehäuse 34 auf. Eine elektrische Verbindung ist vom Erdbelag 33 durch das Durchführungsgehäuse 34 isoliert nach außen geführt und bildet den Hochspannungspol 7 eines Messanschlusses 4. Das Außengehäuse des Messanschlusses 4 ist in der Regel geerdet und dient als Erdpol 8.

Ein Messsystem 1 zur Überwachung der Hochspannungsdurchführung 2 ist an den Messanschluss 4 angeschlossen. Den mechanischen und elektrischen Kontakt zum Messanschluss 4 stellt ein Anschlussstecker 3 her. Von diesem führt ein Anschlusskabel 6 zur Messschaltung 5. Das Anschlusskabel 6 ist beispielsweise als Koaxialkabel ausgeführt, wobei der Innenleiter 42 an den Hochspannungspol 7 angeschlossen wird, und der Außenleiter 41 an den Erdpol 8. Eine Schutzschaltung 10 ist mit dem Anschlusskabel 6 verbunden. Die Schutzschaltung 10 ist hier zur besseren Darstellung zwischen Anschlussstecker 3 und Messschaltung 5 gezeigt. Sie kann jedoch auch in der Messschaltung oder im Anschlussstecker integriert angeordnet sein.

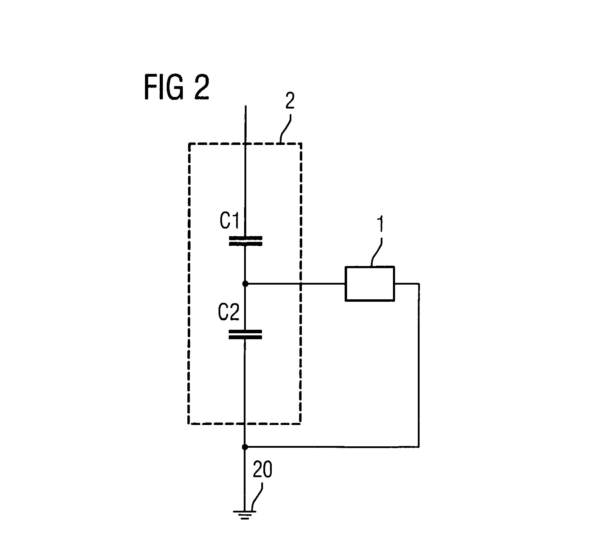

Die Figur 2 zeigt ein Ersatzschaltbild der Anordnung nach Figur 1. Die Durchführung 2 ist als Reihenschaltung von Kondensatoren C1 und C2 dargestellt. Dabei entspricht der Kondensator C2 der Kapazität aus Erdbelag 33 und Erde 20 und der Kondensator C1 der Kapazität der Zusammenschaltung aller anderen Steuerbeläge 33.

Ein Abgriff zwischen den Kondensatoren C1 und C2 bildet den Hochspannungspol 7 des Messanschlusses 4. Der Hochspannungspol 7 ist also elektrisch mit dem Erdbelag 33 verbunden. In einen Schaltkreis zwischen diesem Abgriff und der Erde 20 ist dass Messsystem 1 eingeschaltet.

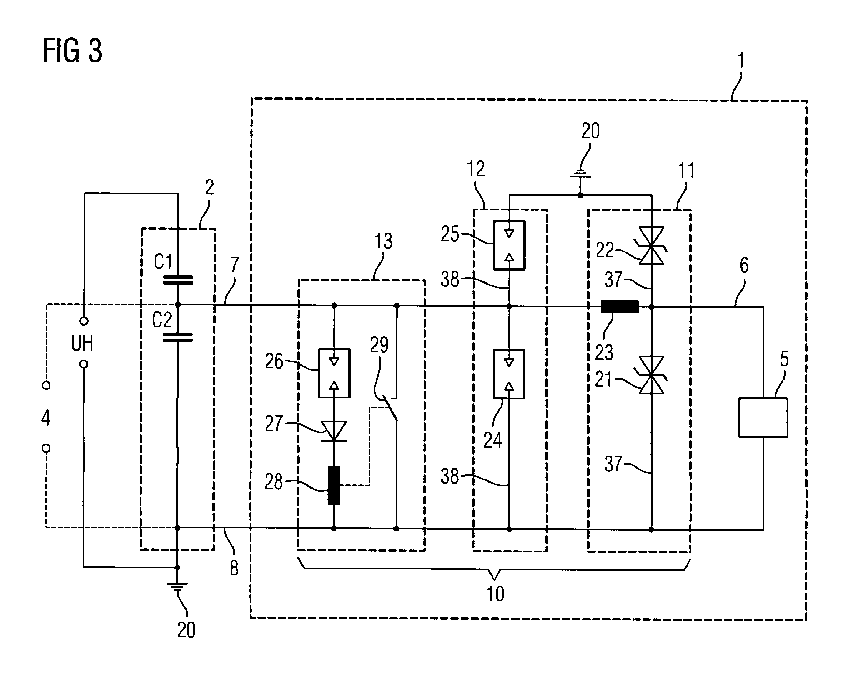

Die Figur 3 zeigt eine Schaltskizze eines erfindungsgemäßen Messsystems 1, insbesondere der Schutzschaltung 10. Die Hochspannungsdurchführung ist hier wieder in der Ersatzschaltung der Kondensatoren C1 und C2 gezeigt.

Zwischen dem innersten Schichtbelag, also dem dem Hochspannung führenden Leiter 31 nächsten, und der Erde 20 liegt eine Hochspannung UH an. Eine Messschaltung 5, wie sie aus dem Stand der Technik bekannt ist, ist parallel zum Messanschluss 4 geschaltet. Die Messschaltung 5 ist in Ihrer Kapazität oder ihrem ohmschen Widerstand so dimensioniert, dass die an dem Messanschluss 4 anliegende Spannung so weit reduziert ist, dass sie von der Isolation 35 des Messanschlusses 4 zwischen Hochspannungspol 7 und Erdpol 8 abgebaut werden kann, ohne dass diese Isolierung 35 durch Teilentladungen geschädigt werden kann. Wie hoch diese Spannung dazu werden kann, hängt von der Dimensionierung der Isolierung 35 ab, liegt aber typisch bei einigen hundert Volt.

Zwischen dem Messanschluss 4 und der Messschaltung 5 sind jeweils parallel zum Messanschluss 4 drei Schutzstufen 11, 12, 13 einer Schutzschaltung 10 geschaltet.

In einem Schaltungszweig 37 parallel zum Messanschluss 4 ist eine Suppressordiode 21 geschaltet. Unterhalb einer ersten Ansprechspannung U1 ist diese hochohmig, hat also einen ohmschen Widerstand, der wesentlich höher ist, als der der Messschaltung 5. Bei Überschreiten der ersten Ansprechspannung U1, beispielsweise bei 100 Volt, wird sie leitend, ihr ohmscher Widerstand reduziert sich dabei um mehrere Größenordnungen, und schließt so Hochspannungspol 7 und Erdpol 8 des Messanschlusses kurz. Der ohmsche Widerstand der Suppressordiode 21 ist dann so gering, dass sich am Messanschluss 4 eine für seine Isolierung 35 unkritische Spannung einstellt, die im Bereich der ersten Ansprechspannung U1 liegt. Dabei fließt je nach Typ der Hochspannungsdurchführung und Höhe der Hochspannung ein Strom von einigen Milliampere bis zu 100 Milliampere durch die Suppressordiode. Eine zweite, identische Suppressordiode 22 ist parallel zur Suppressordiode 21 geschaltet und bildet so einen redundanten Zweig der ersten Schutzstufe 11. Statt Suppressordioden 21, 22 können auch Varistoren oder Bauteile mit ähnlicher Strom- Spannungscharakteristik wie die Suppressordiode 21 verwendet werden. Zwischen den Schaltungszweig 37 und den Hochspannungspol 7 ist ein Tiefpassfilter 23, hier in Form einer Induktivität, geschaltet. Der Tiefpassfilter 23 ist so dimensioniert, dass Frequenzen, die der Betriebsfrequenz des Transformators 30 entsprechen, also etwa 50-60 Hertz, ungehindert passieren, wogegen deutlich höhere Frequenzen gedämpft werden. Tiefpassfilter 23 und eine oder beide Suppressordioden 21, 22 bilden zusammen die erste Schutzstufe 11.

Zwischen der ersten Schutzstufe 11 und dem Messanschluss 4 ist eine zweite Schutzstufe 12 geschaltet. Ein parallel zum Messanschluss 4 geschalteter Schaltungszweig 38 weist dabei eine Funkenstrecke 24, die beispielsweise eine Schutzfunkenstrecke oder ein Gasableiter sein kann, auf. Unterhalb einer zweiten Ansprechspannung U2 ist diese hochohmig, hat also einen ohmschen Widerstand, der wesentlich höher ist, als der der Messschaltung 5. Bei Überschreiten der zweiten Ansprechspannung U2, wird sie leitend, ihr ohmscher Widerstand reduziert sich dabei um mehrere Größenordnungen, und stellt einen Kurzschluss zwischen Hochspannungspol 7 und Erdpol 8 her. Die zweite Ansprechspannung U2 ist dabei höher als die erste Ansprechspannung U1 und beträgt beispielsweise 150 Volt. Eine zweite identische Funkenstrecke 25 ist zu dem Schaltungszweig 38 parallel geschaltet und bildet so einen redundanten Zweig der zweiten Schutzstufe 12. Funkenstrecken 24, 25 sind als Bauteile erhältlich, die bereits zwei separate Funkenstrecken 24, 25 enthalten. Eine redundant ausgeführte zweite Schutzstufe 12 ist so sehr kompakt und leicht zu implementieren. Die redundanten Zweige der ersten und/oder zweiten Schutzstufe 11, 12 können bei geringeren Sicherheitsanforderungen allerdings auch entfallen.

Überspannungen am Messanschluss 4 können verschiedene Ursachen haben. Eine ist der Verlust der Messbürde. Dazu kommt es, wenn ein Defekt an der Messschaltung 5 auftritt, beispielsweise durch Korrosion oder Alterung von Bauelementen, oder beim Bruch des Verbindungskabels 6 zwischen Messanschluss 4 und Messschaltung 5 oder Schutzschaltung 10. Tritt der Bruch des Verbindungskabels 6 zwischen Messanschluss 4 und Schutzschaltung 10 auf, so kann die Schutzschaltung 10 ihre Aufgabe, nämlich einen Kurzschluss am Messanschluss 4 herzustellen, nicht mehr wahrnehmen. Deswegen ist die Schutzschaltung 10 möglichst nahe am Messanschluss 4, bevorzugt im Anschlussstecker 3 integriert, anzuordnen. Beim Bruch des Verbindungskabels 6 zwischen Schutzschaltung 10 und Messschaltung 5 oder bei einem Defekt in der Messschaltung 5 kann eine Überspannung am Messanschluss 4 auftreten. Diese Überspannung ist eine Wechselspannung mit der Betriebsfrequenz des Transformators 30. Ein solches Ereignis wird daher auch betriebsfrequent genannt. Diese betriebsfrequente Wechselspannung kann den Tiefpassfilter 23 nahezu ungehindert passieren. Diese Überspannung liegt daher sowohl an der ersten Schutzstufe 11, als auch an der zweiten Schutzstufe 12 der Schutzschaltung 10 an. Übersteigt die Überspannung die Ansprechspannung U1 der ersten Schutzstufe 11, wird zumindest eine der beiden Suppressordioden 21, 22 leitend, schließt so den Messanschluss 4 kurz und begrenzt damit die Spannung am Messanschluss 4 auf einen für die Isolierung 35 des Messanschlusses 4 unschädlichen Wert. Die Suppressordiode 21 oder ein äquivalentes Bauelement sollte so ausgelegt sein, das sie/es den nun über sie/es fließenden Strom längere Zeit, beispielsweise bis zur nächsten geplanten Wartung der Durchführung 2, tragen kann, ohne zerstört zu werden. Bei der nächsten Wartung der Durchführung 2 kann nun der Defekt am Verbindungskabel 6 oder an der Messschaltung 5 behoben werden. Die Spannung am Messanschluss 4 wird danach wieder durch die Messschaltung 5 begrenzt.

Eine weitere mögliche Ursache für eine Überspannung am Messanschluss 4 kann ein Blitzeinschlag in oder in die Nähe der Durchführung 2 sein. Ein solcher ist ein kurzes, vorübergehendes Ereignis, das am Messanschluss 4 zu sehr hohen Überspannungen führen kann. Dabei treten allerdings im Gegensatz zum Voran beschriebenen Frequenzen auf, die deutlich über der Betriebsfrequenz des Transformators 30 liegen. Daher heißt ein solches Ereignis hochfrequent. Der Tiefpassfilter 23 dämpft diese, so dass die auftretende Überspannung an der oder den Suppressordioden 21, 22 der ersten Schutzstufe 11 in ihrer Amplitude verringert und/oder zeitverzögert anliegt. An der zweiten Schutzstufe 12 liegt diese Überspannung jedoch unverzögert und in voller Höhe an. Deswegen schaltet trotz der höheren Ansprechspannung U2 eine oder beide der Funkenstrecken 24, 25 auf leitend und schließt den Messanschluss 4 kurz. Ohne den Tiefpassfilter 23 würden bei einem solchen hochfrequenten Ereignis statt der zweiten Schutzstufe 12 die erste Schutzstufe 11 schalten, da sie zum Einen eine niedrigere Ansprechspannung U1 aufweist und zum Anderen die Suppressordioden 21, 22 üblicherweise ein schnelleres Ansprechverhalten haben, also eine kürzere Umschaltzeit von hochohmig auf leitend, als die Funkenstrecken 24, 25. Da bei einem hochfrequenten Ereignis sehr viel höhere Überspannungen auftreten können, als bei einem betriebsfrequenten, und wegen der Frequenzabhängigkeit der Kapazität C1 sind dort auch die über den Kurzschluss fließenden Ströme höher und können mehrere hundert Ampere betragen. Solche hochfrequenten Ereignisse werden durch die Schaltungsanordnung der ersten und zweiten Schutzstufe 11, 12 mittels der Funkenstrecken 24, 25 geschaltet, die deutlich höhere Ströme tragen können, als die Suppressordioden 21, 22. Die erste Schutzstufe 11 schaltet also vorzugsweise bei betriebsfrequenten Überspannungen, die zweite Schutzstufe 12 bei hochfrequenten. Sollte die erste Schutzstufe 11 ausfallen, so schaltet die zweite Schutzstufe 12 auch bei einem betriebsfrequenten Ereignis, allerdings erst bei der höheren Ansprechspannung U2. Fällt die zweite Schutzstufe 12 aus, so schaltet die erste Schutzstufe 11 auch bei einem hochfrequenten Ereignis allerdings durch den Tiefpassfilter 23 zeitverzögert.

Sollte das die Überspannung auslösende Ereignis beendet sein, was im Falle eines Blitzeinschlags bereits nach wenigen Sekundenbruchteilen der Fall sein kann, im Falle einer Reparatur, beispielsweise eines Bruchs des Verbindungskabels 6, auch Monate dauern kann, so fällt die an der ersten oder zweiten Schutzstufe 11, 12 anliegende Spannung wieder unter die Ansprechspannungen U1, U2. Die Funkenstrecken 24, 25 beziehungsweise die Suppressordioden 21, 22 werden wieder hochohmig, der Kurzschluss des Messanschlusses wird wieder geöffnet. Der von der ersten oder zweiten Schutzstufe 11, 12 hergestellte Kurzschluss ist also reversibel und wird geöffnet, wenn das die Überspannung auslösende Ereignis beendet ist.

Die erste und die zweite Schutzstufe 11, 12 sprechen also auf unterschiedliche Ereignisse an, dienen sich gegenseitig jedoch als Rückfallebene, falls eine der Schutzstufen 11, 12 ausfällt.

Tritt ein Blitzeinschlag nach einem Ausfall der zweiten Schutzstufe 12 auf, so kann die erste Schutzstufe 11 durch die hohen auftretenden Ströme zerstört werden, und ebenfalls ausfallen. Da außerdem über das Langzeitverhalten der in der ersten oder zweiten Schutzstufe 11, 12 verwendeten Bauelemente heute noch wenig bekannt ist, insbesondere wenn sie über längere Zeit im geschalteten, also leitenden, Zustand betrieben werden, ist nicht auszuschließen, dass beide Schutzstufen 11 ,12 ausfallen. Für diesen Fall ist eine dritte Schutzebene 13 vorgesehen, die allerdings für niedrigere Sicherheitsanforderungen auch entfallen kann.

Die dritte Schutzstufe 13 ist parallel zum Messanschluss 4 zwischen diesem und der zweiter Schutzstufe 12 geschaltet und weist eine Reihenschaltung aus einer Funkenstrecke 26, einem Gleichrichter 27, hier einer Diode, und einer Spule 28 auf. Die Funkenstrecke 26 ist dabei mit dem Hochspannungspol 7 verbunden, die Spule 28 mit dem Erdpol 8. Parallel zu dieser Reihenschaltung ist ein mechanischer Schalter 29 zwischen Hochspannungspol 7 und Erdpol 8 geschaltet. Der Schalter 29 und die Spule 28 bilden ein Reed-Relais. Ist die Spule 28 nicht von einem Strom durchflossen, so ist der Schalter 29 geöffnet. Wird die Spule 28 von einem Gleichstrom oder einem gleichgerichteten Wechselstrom durchflossen, so wird durch das sich dadurch aufbauende Magnetfeld der Spule 28 der Schalter 29 geschlossen und stellt so einen Kurzschluss des Messanschlusses 4 her. Die Funkenstrecke 26 weist eine Ansprechspannung U3 auf, bei der sie leitend wird. Der Strom, der dann durch die Funkenstrecke 26 fließt, wird durch den Gleichrichter 27 gleichgerichtet und baut in der Spule 28 ein Magnetfeld auf. Die Spule 28 ist so bemessen, insbesondere in ihrer Windungszahl, dass bei dem dann fließenden Strom der Schalter 29 geschlossen wird. Der Strom fließt nun über den Schalter 29, wodurch die Spannung am Messanschluss 4 unter die Ansprechspannung U3 fällt, die Funkenstrecke 26 erlischt und wird wieder hochohmig. Die Spule 28 wird dann nicht mehr stromdurchflossen, und das Magnetfeld baut sich ab. Der Schalter 29 ist bistabil, bleibt also im geschlossenen Zustand, auch wenn das Magnetfeld abgebaut ist. Durch ein dem zum Schließen des Schalters 29 benötigten Magnetfeld entgegen gesetztes Magnetfeld kann der Schalter 29 wieder geöffnet werden. Dies kann mit einem Dauermagneten erreicht werden, der an eine geeignete Stelle in der Nähe des Schalters 29 gehalten wird. Wird die Schutzschaltung 10 oder auch nur die Schutzstufe 13 im Anschlussstecker 3 integriert, so kann am Anschlussstecker 3 eine Markierung vorgesehen sein, die angibt, wo und in welcher Orientierung ein Dauermagnet zur Öffnung des Schalters 29 positioniert sein muss. Der Schalter 29 kann alternativ geöffnet werden, indem an die Spule 28 eine der Ansprechspannung U3 entgegen gesetzte Gegenspannung, beispielsweise mit einer zusätzlichen Spannungsquelle, angelegt wird, oder indem dafür eine weitere Spule vorgesehen ist, die beispielsweise auf einen Schaltimpuls aus der Leitwarte stromdurchflossen wird und dadurch ein zum Öffnen des Schalters 29 geeignetes Magnetfeld aufbaut.

Die Ansprechspannung U3 der Funkenstrecke 26 ist auch die Ansprechspannung der dritten Schutzstufe 13 und ist so bemessen, dass sie größer als die Ansprechspannung U2 der zweiten Schutzstufe 12 ist. Die dritte Schutzstufe 13 könnte allerdings auch als erste Ausfallebene wirken, und die erste und zweite Schutzstufe 11, 12 als deren Rückfallebenen. Dann wäre die Ansprechspannung U3 kleiner als die Ansprechspannung U1 zu dimensionieren.

Sollte eine Überspannung auftreten, wenn sowohl erste, als auch zweite Schutzebene 11, 12 ausgefallen sind, oder wenn eine Überspannung zu einem sukzessiven Ausfall der ersten und zweiten Schutzebene 11, 12 führt, so würde, wenn die Überspannung die Ansprechspannung U3 übersteigt, die dritte Schutzebene 13 den Messanschluss 4 kurzschließen. Da mechanische Schalter 29 hohe Ströme tragen können, und als robust und ausfallsicher gelten, stellt eine solche dritte Schutzstufe 13 einen hohen Schutz des Messanschlusses 4 vor Überspannungen dar. Anders als bei der ersten oder zweiten Schutzstufe 11, 12 ist hier allerdings ein manueller Eingriff zum Öffnen des Kurzschlusses notwendig, weshalb die dritte Schutzstufe 13 bevorzugt als Ausfallsicherung der ersten und zweiten Schutzstufe 11, 12 dient.

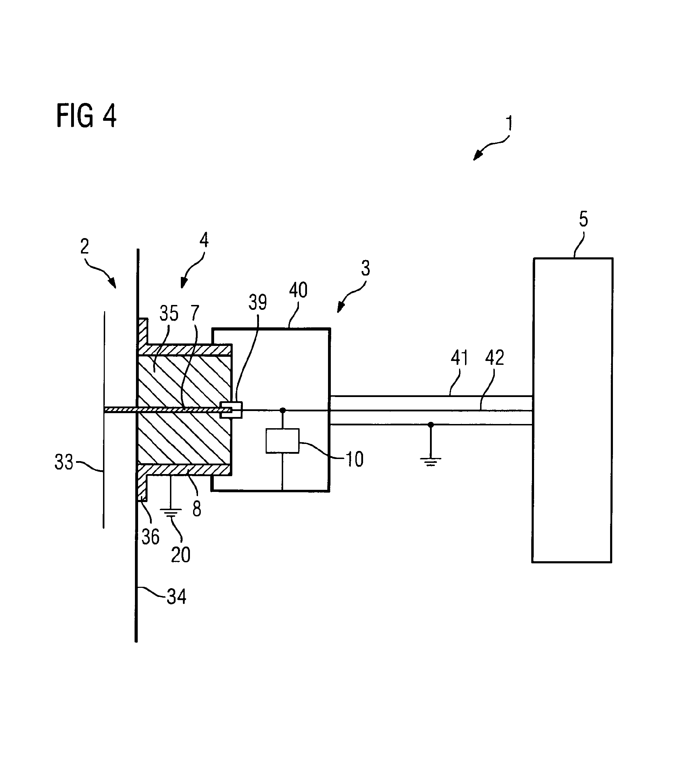

Die Figur 4 zeigt eine Skizze eines erfindungsgemäßen Messsystems 1 mit einer im Gehäuse 40 des Anschlusssteckers 3 integrierten Schutzschaltung 10. Die Schutzschaltung 10 kann dabei so ausgeführt sein, wie in Figur 3 gezeigt. Vom Erdbelag 33 der Hochspannungsdurchführung 2 führt eine elektrische Verbindung zum Hochspannungspol 7 des Messanschlusses 4. Ein geerdeter Flansch 36 am Durchführungsgehäuse 34 bildet das Außengehäuse des Messanschlusses 4 und damit dessen Erdpol 8. Zwischen dem Hochspannungspol 7 und dem Außengehäuse befindet sich eine Isolierung 35, die den Hochspannungspol 7 gegen die Erde 20 isoliert und den Messanschluss 4 gleichzeitig abdichtet, so dass keine Luft oder Feuchtigkeit in die Hochspannungsdurchführung 2 gelangen kann. Auf den Messanschluss 4 ist der Anschlussstecker 3 aufgesteckt. Eine Steckbuchse 39 im Anschlussstecker 3 stellt die elektrische Verbindung zum Hochspannungspol 7 her. Das Gehäuse 40 des Anschlusssteckers 3 ist elektrisch leitend und stellt über den Flansch 36 die Verbindung zur Erde 20 her. Die Schutzschaltung 10 ist im Inneren des Gehäuses 40 des Anschlusssteckers 3 angeordnet. Eine Schutzschaltung 10, wie sie im Vorangegangenen beschrieben ist, besteht aus Bauteilen, die sehr kompakt sind, teilweise kleiner als ein Millimeter. Dadurch lässt sich eine Schutzschaltung 10 mit zwei oder drei Schutzstufen 11, 12, 13 in einem Anschlussstecker 3 unterbringen, dessen Abmessungen durch ein häufig geringes Raumangebot im Bereich des Messanschlusses 4 begrenzt sind. Die Schutzschaltung 10 ist im Inneren des Anschlusssteckers 3 elektrisch mit der Steckbuchse 39 und über das Gehäuse 40 des Anschlusssteckers 3 mit der Erde 20 verbunden. Auf der dem Messanschluss 4 abgewandten Seite des Anschlusssteckers 3 ist das Verbindungskabel 6 angeordnet. Dieses ist als Koaxialkabel ausgeführt. Der Innenleiter 41 ist dabei elektrisch mit dem Hochspannungspol 7 verbunden, der Außenleiter 42 über das Gehäuse des Anschlusssteckers 3 mit der Erde 20. Die Verbindung kann fest oder lösbar, beispielsweise mit einem Bajonettverschluss, ausgeführt sein. Das andere Ende des Verbindungskabels 6 ist mit der Messschaltung 5 verbunden. Auch diese Verbindung kann fest oder lösbar ausgeführt sein.

## Patentansprüche

1. Messsystem (1) zur Dauerüberwachung einer Hochspannungsdurchführung (2), insbesondere einer Gehäusedurchführung eines Leistungstransformators, aufweisend
- eine Messschaltung (5) zur Überwachung der Hochspannungsdurchführung (2),
- einen Anschlussstecker (3) zum Anschluss der Messschaltung (5) an einen Messanschluss (4) der Hochspannungsdurchführung (2),
- ein Verbindungskabel (6) zur Verbindung der Messschaltung (5) mit dem Anschlussstecker (3), und
- eine Schutzschaltung (10) zum Schutz des Messanschlusses (4) vor Überspannungen, die dazu ausgebildet ist, einen Kurzschluss zwischen einem Hochspannungspol (7) und einem Erdpol (8) des Messanschlusses (4) bei Auftreten einer Überspannung herzustellen, wobei die Schutzschaltung (10) eine erste Schutzstufe (11) mit einer ersten Ansprechspannung (U1) und dazu elektrisch parallel geschaltet eine zweite Schutzstufe (12) mit einer zweiten Ansprechspannung (U2) aufweist,
**dadurch gekennzeichnet,**
**dass** die zweite Ansprechspannung (U2) größer als die erste Ansprechspannung (U1) ist, dass die zweite Schutzstufe (12) zwischen Messanschluss (4) und erster Schutzstufe (11) geschaltet ist und dass die erste Schutzstufe (11) einen Tiefpassfilter (23) aufweist.

2. Messsystem (1) nach Anspruch 1,
**dadurch gekennzeichnet,**
**dass** die erste Schutzstufe (11) in einem den Hochspannungspol (7) mit dem Erdpol (8) verbindenden Schaltungszweig (37) einen Varistor oder eine Suppressordiode (21) aufweist.

3. Messsystem (1) nach einem der Ansprüche 1 oder 2,
**dadurch gekennzeichnet,**
**dass** die zweite Schutzstufe (12) in einem den Hochspannungspol (7) mit dem Erdpol (8) verbindenden Schaltungszweig (38) eine Funkenstrecke (24) aufweist.

4. Messsystem (1) nach einem der Ansprüche 1 bis 3,
**dadurch gekennzeichnet,**
**dass** eine dritte Schutzstufe (13) zwischen dem Messanschluss (4) und der ersten Schutzstufe (11) parallel zum Messanschluss (4) geschaltet ist und einen mechanischen Schalter (29) aufweist, durch den bei Anliegen einer dritten Ansprechspannung (U3) der Kurzschluss herstellbar ist.

5. Messsystem (1) nach Anspruch 4,
**dadurch gekennzeichnet,**
**dass** die dritte Schutzstufe (13) eine Reihenschaltung aus einer Funkenstrecke (26), einem Gleichrichter (27) und einer Spule (28) aufweist, und der mechanische Schalter (29) durch einen Stromfluss durch die Spule (28) schaltbar ist und so mit der Spule (28) ein Reed-Relais bildet.

6. Messsystem (1) nach Anspruch 5,
**dadurch gekennzeichnet,**
**dass** das Reed-Relais bistabil ist.

7. Messsystem (1) nach einem der Ansprüche 1 bis 6,
**dadurch gekennzeichnet,**
**dass** zumindest eine der Schutzstufen (11, 12, 13) redundant ausgelegt ist

8. Messsystem (1) nach einem der Ansprüche 1 bis 7
**dadurch gekennzeichnet,**
**dass** die Schutzschaltung (10) im Anschlussstecker (3) integriert ist.
